# EUROPÄISCHE PATENTANMELDUNG

(11) **EP 2 455 977 A1**
(43) Veröffentlichungstag der Anmeldung: **23.05.2012**
(21) Anmeldenummer: 10191397.8
(22) Anmeldetag: 16.11.2010
(51) Int. Cl.: H01L 31/042

(54) **Photovoltaikanlage**

(71) Anmelder: SIEMENS AKTIENGESELLSCHAFT, 80333 München (DE)
(72) Erfinder: Milvich, Michael, 68753, Waghäusel (DE); Schmitt, Franz-Josef, 76865, Insheim (DE)

(57) **Zusammenfassung**

Die Erfindung betrifft eine Photovoltaikanlage mit mehreren Solarmodulen, die eine Vielzahl von verschalteten Solarzellen aufweisen und die derart verbunden sind, dass die Solarmodule mehrere Teilgeneratoren (8, 9, 10, 11) bilden, und mit mehreren Wechselrichtern (12, 13) zum Anschluss der Teilgeneratoren. Dadurch, dass für jeden Teilgenerator (8, 9, 10, 11) eine Einrichtung (14, 15, 16, 17) zur Erfassung der erzeugten elektrischen Leistung des Teilgenerators (8, 9, 10, 11) und ein steuerbares Schaltmittel (4, 5, 6, 7) vorgesehen sind, welches zum Verbinden des Teilgenerators (8, 9, 10, 11) mit einem der Wechselrichter (12, 13) vorgesehen ist, wird ein effizienterer Einsatz der Wechselrichter (12, 13) ermöglicht.

## Beschreibung

Die Erfindung betrifft eine Photovoltaikanlage mit mehreren Solarmodulen, die eine Vielzahl von verschalteten Solarzellen aufweisen und die derart verbunden sind, dass die Solarmodule mehrere Teilgeneratoren bilden, und mit mehreren Wechselrichtern zum Anschluss der Teilgeneratoren.

Gewöhnlich bildet ein Solargenerator eine elektrische Einheit oder kann in einzelne elektrisch unabhängige Teilgeneratoren unterteilt sein, die jeweils mehrere z. B. auf einem Dach eines Gebäudes montierte und gleich ausgerichtete Solarmodule umfassen. Jeder Teilgenerator ist an einen Wechselrichter angeschlossen, der die erzeugte Gleichspannung in eine Wechselspannung umsetzt, wobei der Wirkungsgrad des Wechselrichters von der erzeugten elektrischen Leistung des Teilgenerators abhängt. Eine schwache Sonneneinstrahlung, beispielsweise aufgrund einer Verschattung eines Solarmoduls oder mehrerer Solarmodule und/oder aufgrund einer tageszeitbedingten Änderung der Sonnenposition, bewirkt, dass der Teilgenerator eine geringe Leistung erzeugt und dadurch der Wechselrichter im unteren Lastbereich betrieben wird. Im unteren Lastbereich ist der Wirkungsgrad des Wechselrichters gering, nur im Rahmen einer hohen Auslastung arbeitet der Wechselrichter effizient. Wegen der zentralen Bedeutung der Wechselrichter in Photovoltaikanlagen, die im Falle von defekten Wechselrichtern ausfallen, der im Unterschied zu den Solarmodulen geringen Lebensdauer sowie des geringen Preisverfalls der Wechselrichter, ist ein effizienterer Betrieb der Wechselrichter wünschenswert.

Der Erfindung liegt daher die Aufgabe zugrunde, eine Photovoltaikanlage der eingangs genannten Art zu schaffen, die einen effizienteren Einsatz der Wechselrichter ermöglicht. Diese Aufgabe wird durch die im kennzeichnenden Teil des Anspruchs 1 angegebenen Maßnahmen gelöst.

Vorteilhaft ist, dass die Wechselrichter flexibel eingesetzt werden können. Die Wechselrichter sind "dynamisch" zuteilbar und die Anzahl der Wechselrichter kann verringert werden. Beispielsweise für den Fall, dass ein Gebäudekomplex sowohl in Richtung Osten als auch in Richtung Süden und Westen mit jeweils einem Teilgenerator versehen ist, der jeweils eine Vielzahl von gleich ausgerichteten Solarmodulen aufweist, kann ein Wechselrichter, der morgens mit dem in Richtung Osten ausgerichteten Teilgenerator verschaltet war, abends mit dem in Richtung Westen ausgerichteten Teilgenerator verschaltet werden, weil die erzeugte Leistung bzw. der Ertrag des in Richtung Osten ausgerichteten Teilgenerators am Abend unbedeutend ist. In diesem Fall kann auf einen Wechselrichter verzichtet werden; es ist lediglich ein Wechselrichter für die nach Osten und Westen ausgerichteten Teilgeneratoren vorgesehen.
Es wird ferner die Möglichkeit geschaffen, z. B. einen bereits mit Teilgeneratoren versehenen Gebäudekomplex mit weiteren verschieden ausgerichteten Teilgeneratoren auszustatten, ohne einen weiteren kostenintensiven Wechselrichter einzusetzen, wobei der oder - je nach Anzahl von eingesetzten Wechselrichtern - der aktuell leistungsstärkste oder die aktuell leistungsstärksten Teilgeneratoren dem oder den Wechselrichtern zugeschaltet werden und eine weitgehende konstante Grundversorgung des Gebäudekomplexes mit Energie erzielt wird.

In einer Ausgestaltung der Erfindung ist vorgesehen, dass die Schaltmittel über einen Bus mit einer Steuerung verbunden sind, welche die erfasste elektrische Leistung jedes Teilgenerators auswertet und in Abhängigkeit der Auswerteergebnisse die Schaltmittel der Teilgeneratoren steuert. Dadurch wird die Ansteuerung der Schaltmittel erleichtert und die dynamische Zuteilung eines Wechselrichters zu einem Teilgenerator vereinfacht.

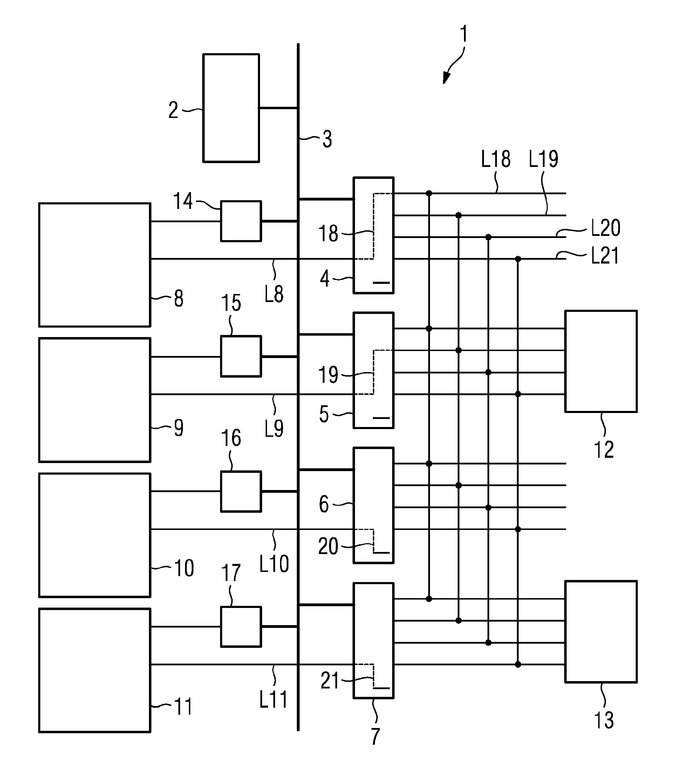

Die Erfindung wird nachfolgend anhand eines Ausführungsbeispiels unter Bezugnahme auf die einzige Figur der Zeichnung näher erläutert. Die Figur der Zeichnung zeigt in schematischer Darstellung Bestandteile einer Photovoltaikanlage.

Eine mit 1 bezeichnete Photovoltaikanlage umfasst eine speicherprogrammierbare Steuerung 2, welche über einen Bus 3 mit steuerbaren Schaltmitteln 4, 5, 6, 7 verbunden ist. Jedes der Schaltmittel 4 bis 7 ist zum Verbinden eines von vier Teilgeneratoren 8, 9, 10, 11, die jeweils eine Vielzahl von gleich ausgerichteten Solarmodulen aufweisen, mit einem der Wechselrichter 12, 13 oder zum Trennen des jeweiligen Teilgenerators 8 bis 11 von einem dieser Wechselrichter 12, 13 vorgesehen. Im vorliegenden Ausführungsbeispiel ist das Schaltmittel 4 dem Teilgenerator 8 zugeordnet, das Schaltmittel 5 dem Teilgenerator 9, das Schaltmittel 6 dem Teilgenerator 10 sowie das Schaltmittel 7 dem Teilgenerator 11. Der Einfachheit halber und im Hinblick auf eine übersichtlichere Darstellung ist in der Zeichnung für jeden Teilgenerator 8 bis 11 jeweils nur eine Stromleitung L8, L9, L10, L11 eingezeichnet, die über die Schaltmittel 4 bis 7 und über Stromkabel L18, L19, L20, L21 mit den Wechselrichtern 12, 13 verbunden werden kann. Selbstverständlich sind je nach Verschaltung der Solarmodule - beispielsweise Reihen- und/oder Parallelschaltung der Solarmodule oder der Solarmodul-Stränge - für jeden Teilgenerator 8 bis 11 mehrere Stromleitungen zum Verbinden mit den Wechselrichtern 12, 13 erforderlich. Dies bedeutet, dass das jeweilige Schaltmittel 4 bis 7 derart ausgestaltet ist, dass dieses mehrere an einen Teilgenerator 8 bis 11 angeschlossene Stromleitungen mit mehreren an den Wechselrichter 12, 13 angeschlossenen Stromleitungen gleichzeitig verbindet bzw. kurzschließt.

Jedem Teilgenerator 8 bis 11 ist eine Einrichtung 14, 15, 16, 17 zugeordnet, welche die aktuell erzeugte elektrische Leistung durch eine Strom- und Spannungsmessung des jeweiligen Teilgenerators 8 bis 11 erfasst und nach einer A/D-Wandlung einen dieser Leistung entsprechenden digitalen Wert über den Bus 3 der Steuerung 2 übermittelt. Die Steuerung 2, die Schaltmittel 4 bis 7, die Einrichtungen 14 bis 17 sowie die Wechselrichter 12, 13 können räumlich zusammen in einem Gebäude untergebracht sein. Vorzugsweise sind die Einrichtungen 14 bis 17 in der Nähe der Teilgeneratoren 8 bis 11 angeordnet, um den Verdrahtungsaufwand zu verringern.

Die Steuerung 2 wertet die übermittelten aktuellen Leistungen der Teilgeneratoren 8 bis 11 aus und verbindet zwei der vier Teilgeneratoren 8 bis 11, deren aktuellen Leistungen am höchsten sind, jeweils mit einem der Wechselrichter 12, 13, welche dadurch in einem effizienten Lastbereich betrieben werden.
Im vorliegenden Ausführungsbeispiel wird angenommen, dass die Teilgeneratoren 8, 9 die aktuell höchsten Leistungen erzeugen. Aufgrund dessen schaltet die Steuerung 2 die Schaltmittel 4 und 5 derart, dass der Teilgenerator 8 über die Stromleitungen L8 und L18 mit dem Wechselrichter 12 und der Teilgenerator 9 über die Stromleitungen L9 und L19 mit dem Wechselrichter 13 verbunden ist, was in der Zeichnung durch eine punktierte Linie 18, 19 in den Schaltmitteln 4 und 5 angedeutet ist. Ferner schaltet die Steuerung 2 die Schaltmittel 6 und 7 in eine Ruheposition (punktierte Linie 20, 21), in welcher die Teilgeneratoren 10 und 11 von den Wechselrichtern 12, 13 getrennt sind.
Die Steuerung 2 wertet weiterhin Leistungsdaten der Teilgeneratoren 8 bis 11 zyklisch oder nach vorgebbaren Zeiten aus, erkennt Leistungsänderungen und weist wiederum den beiden Teilgeneratoren 8 bis 11 mit den höchsten Erträgen die Wechselrichter 12, 13 zu.

## Patentansprüche

1. Photovoltaikanlage mit mehreren Solarmodulen, die eine Vielzahl von verschalteten Solarzellen aufweisen und die derart verbunden sind, dass die Solarmodule mehrere Teilgeneratoren (8, 9, 10, 11) bilden, und mit mehreren Wechselrichtern (12, 13) zum Anschluss der Teilgeneratoren (8, 9, 10, 11), **dadurch gekennzeichnet, dass** für jeden Teilgenerator (8, 9, 10, 11) vorgesehen ist:
- eine Einrichtung (14, 15, 16, 17) zur Erfassung der erzeugten elektrischen Leistung des Teilgenerators (8, 9, 10, 11) und
- ein steuerbares Schaltmittel (4, 5, 6, 7) zum Verbinden des Teilgenerators (8, 9, 10, 11) mit einem der Wechselrichter (12, 13).

2. Photovoltaikanlage nach Anspruch 1, **dadurch gekennzeichnet, dass** die Schaltmittel (4, 5, 6, 7) über einen Bus (3) mit einer Steuerung (2) verbunden sind, welche die erfasste elektrische Leistung jedes Teilgenerators (8, 9, 10, 11) auswertet und in Abhängigkeit der Auswerteergebnisse die Schaltmittel (4, 5, 6, 7) der Teilgeneratoren (8, 9, 10, 11) steuert.
